(19) Europäisches Patentamt
European Patent Office
Office européen des brevets

(11) **EP 3 923 009 B1**

(12) **EUROPEAN PATENT SPECIFICATION**

(45) Date of publication and mention
of the grant of the patent:
**21.02.2024 Bulletin 2024/08**

(21) Application number: **20179535.8**

(22) Date of filing: **11.06.2020**

(51) International Patent Classification (IPC):
**G01R 31/52** *(2020.01)*

(52) Cooperative Patent Classification (CPC):
**G01R 31/52**

(54) **A METHOD FOR DETERMINING THE LOCATION OF A GROUND FAULT IN AN ELECTRICAL CIRCUIT AND AN ELECTRICAL CIRCUIT**

VERFAHREN ZUR BESTIMMUNG DES ORTES EINES ERDSCHLUSSES IN EINER ELEKTRISCHEN SCHALTUNG UND ELEKTRISCHE SCHALTUNG

PROCÉDÉ PERMETTANT DE DÉTERMINER L'EMPLACEMENT D'UN DÉFAUT À LA TERRE DANS UN CIRCUIT ÉLECTRIQUE ET CIRCUIT ÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**15.12.2021 Bulletin 2021/50**

(73) Proprietor: **Ellego Powertec Oy**
**24910 Halikko AS (FI)**

(72) Inventors:
• **NURMI, Jari**
**20400 Turku (FI)**
• **VAINIO, Otto**
**20300 Turku (FI)**

(74) Representative: **Berggren Oy**
**P.O. Box 16**
**Eteläinen Rautatiekatu 10A**
**00101 Helsinki (FI)**

(56) References cited:
JP-A- 2012 122 752    JP-A- 2014 016 246
JP-A- 2016 038 357    JP-B2- 6 382 576
JP-U- S5 772 727

• VIDAL DANIEL ET AL: "Aeronautical ground lighting system study: field measurements and simulations", IET GENERATION, TRANSMISSION&DISTRIBUTION, IET, UK, vol. 10, no. 13, 6 October 2016 (2016-10-06), pages 3228-3233, XP006058616, ISSN: 1751-8687, DOI: 10.1049/IET-GTD.2015.1536

**Description**

TECHNICAL FIELD OF THE INVENTION

The present invention relates to a method for determining the location of a ground fault in an electrical circuit and to an electrical circuit according to the preambles of the appended independent claims.

BACKGROUND OF THE INVENTION

Aeronautical ground lighting (AGL) systems provide visual cues in runways and taxiways to help aircraft pilots during approach, landing and taxiing. A conventional AGL system comprises a constant-current regulator (CCR) that supplies electric power through series-connected transformers to luminaires, such as halogen lamps or light-emitting diodes (LEDs). The CCR is a variable voltage source, which provides an adjustable current according to luminaire brightness requirements. The series-connected transformers separate the CCR and the luminaires into primary and secondary circuits. The transformers isolate the luminaires from the high operating voltage of the primary circuit and ensure the circuit continuity in case of a luminaire failure.

A ground fault may occur in an AGL system, for example, due to an insulation breakdown in an electrical cable that is electrically connected between two transformers. The ground fault is a failure that allows an unintended connection of the electrical circuit with the ground. The locating of a ground fault can be difficult and time-consuming because the electrical circuit of the AGL system is typically very long and the electrical cables are mostly buried underground. The known AGL systems do not have any built-in functionalities to determine the location of a ground fault.

Document JP 2012122752 A describes a method and device for determining a ground fault position in an airport lighting system.

OBJECTIVES OF THE INVENTION

It is the main objective of the present invention to reduce or even eliminate the prior art problems presented above.

It is an objective of the present invention to provide a method for determining the location of a ground fault in an electrical circuit. In more detail, it is an objective of the invention to provide a method for determining the location of a ground fault in an electrical circuit that comprises a plurality of transformers, whose primary windings are electrically connected in series and secondary windings are electrically connected to light-emitting diodes.

It is also an objective of the present invention to provide an electrical circuit comprising a plurality of transformers, whose primary windings are electrically connected in series and secondary windings are electrically connected to light-emitting diodes, and having a built-in functionality to determine the location of a ground fault in the electrical circuit.

In order to realise the above-mentioned objectives, the method and the electrical circuit according to the invention are characterised by what is presented in the characterising portions of the appended independent claims. Advantageous embodiments of the invention are described in the dependent claims.

DESCRIPTION OF THE INVENTION

A method according to the invention comprises the steps of claim 1.

The method according to the invention is used to determine the location of a ground fault in an electrical circuit. The ground fault is a failure, such as an insulation breakdown in an electrical cable, that allows an unintended connection of the electrical circuit with the ground. The ground fault creates a path for electrical current to flow directly to the ground.

The method according to the invention is applied in an electrical circuit that comprises a plurality of transformers whose primary windings are electrically connected in series and secondary windings are electrically connected to light-emitting diodes (LEDs). The series-connected primary windings of the transformers form a primary circuit. Each of the secondary windings of the transformers forms a secondary circuit with one of the LEDs.

The constant-current regulator (CCR) is electrically connected to the series-connected primary windings, i.e. to the primary circuit for supplying AC power to the primary windings. The CCR is electrically connected to the first terminal and the second terminal of the series-connected primary windings. The CCR is a variable voltage source, which can provide an adjustable constant current, typically over a wide voltage range. The current supplied by the CCR can be adjusted, for example, according to brightness requirements of the LEDs. The CCR can be configured to provide, for example, a plurality of discrete brightness levels for the LEDs. The CCR supplies electric power through the transformers to the LEDs, which then emit light. The transformers isolate the LEDs from the high operating voltage of the primary circuit and ensure the circuit continuity in case of a LED failure.

A ground fault may occur in the primary circuit, for example due to an insulation breakdown in an electrical cable between the primary windings. In the method according to the invention, the location of such a fault can be determined based on two measured voltages. The voltages that are used in determining the location of the ground fault are the first and second voltages measured over the first and second resistors. A first terminal of the first resistor is electrically connected to the first terminal of the series-connected primary windings, and a first terminal of the second resistor is electrically connected to the second terminal of the series-connected primary windings. Second terminals of the first and second resistors are electrically connected to each other. Preferably, the resistances of the first and second resistors are the same. The resistance of the first resistor and the second resistor can be, for example, from 1 kΩ to 100 MΩ, or 200 kΩ, 1 MΩ or 5 MΩ. The resistance of the first resistor and the second resistor affects the sensitivity of the measurement. The resistance of the first resistor and the second resistor can be kept constant or varied during the measurement.

An advantage of the method according to the invention is that the location of a ground fault in an electrical circuit can be determined in a quick and accurate manner.

According to an embodiment of the invention the location of the ground fault is determined by using an equation:

$$n = \frac{kV_1}{V_1 + V_2}$$

where n denotes the number of the primary windings between the first terminal and the ground fault location, $k$ denotes the total number of the primary windings, $V_1$ denotes the first voltage and $V_2$ denotes the second voltage.

According to an embodiment of the invention the method comprises determining a ground fault resistance and determining the location of the ground fault based on at least the measured first and second voltages and the determined ground fault resistance. The utilization of the ground fault resistance is advantageous in determining the location of the ground fault because the first and second voltages depend not only on the location of the ground fault, but also on the ground fault resistance in the electrical circuit. The utilization of the ground fault resistance thus increases the location accuracy. Each possible location of a ground fault produces a set of curves of a voltage imbalance as a function of the ground fault resistance. The voltage imbalance $\Delta_{\mathrm{UAC}}$ is defined by an equation:

$$\Delta_{\mathrm{UAC}} = \frac{V_1 - V_2}{V_1 + V_2}$$

where $V_1$ denotes the first voltage and $V_2$ denotes the second voltage.

The ground fault resistance can be determined in various ways. Preferably, the step of determining a ground fault resistance comprises using a third resistor having a first terminal and a second terminal, the first terminal being electrically connected to a node between the first resistor and the second resistor, using a power source electrically connected to the second terminal of the third resistor to supply DC power, measuring a current through the third resistor, and calculating the ground fault resistance based on the measured current. The resistance of the third resistor can be, for example, from 1 kΩ to 100 MΩ, or 200 kΩ, 1 MΩ or 5 MΩ. The resistance of the third resistor affects the sensitivity of the measurement. The resistance of the third resistor can be kept constant or varied during the measurement.

The location of the ground fault can be described as a distance between one of the terminals of the series-connected primary windings, i.e. the primary circuit, and the ground fault location. This distance $s_{\mathrm{gl}}$ can be defined as a function of the ground fault resistance $R_{\mathrm{DC}}$ and the voltage imbalance $\Delta_{\mathrm{UAC}}$ as follows:

$$s_{\mathrm{gl}} = \Lambda_{\mathrm{gl}}(R_{\mathrm{DC}}, \Delta_{\mathrm{UAC}}).$$

The imbalance curves $\Lambda_{\mathrm{gl}}$ are circuit specific and they describe the ratio of the accumulated impedance of the circuit branches as a function of the distance from the terminals of the series-connected primary windings. The imbalance curves $\Lambda_{\mathrm{gl}}$ monotonically approach the curve (line) of balance (corresponding to a situation when $V_1 = V_2$, i.e. $\Delta_{\mathrm{UAC}} = 0$) and meet it at a point that corresponds to the electrically furthermost point in the primary circuit. The imbalance curves $\Lambda_{\mathrm{gl}}$ of the electrical circuit are of the same shape but differently scaled depending on the ground fault resistance, and they lie between the curve of balance and the curve of full imbalance (corresponding to a situation when $V_1$ or $V_2 = 0$, i.e. $\Delta_{\mathrm{UAC}} = +1$ or - 1).

Depending on the structure of the electrical circuit, the imbalance curves $\Lambda_{\mathrm{gl}}$ can be symmetrical or asymmetrical relative to the electrical centre of the primary circuit. The sign (polarity) of the voltage difference $\Delta V = V_1 - V_2$ denotes which terminal of the primary circuit is electrically closer to the location of the ground fault. Based on the sign of the voltage difference $\Delta V$, the correct imbalance curve $\Lambda_{\mathrm{gl}}$ can be used in determining the distance between the terminal of the primary circuit and the ground fault location.

According to an embodiment of the invention the step of determining the location of the ground fault based on at least the measured first and second voltages and the determined ground fault resistance comprises calculating the voltage imbalance $\Delta_{UAC}$ by an equation:

$$\Delta_{UAC} = \frac{V_1 - V_2}{V_1 + V_2}$$

where $V_1$ denotes the first voltage and $V_2$ denotes the second voltage; calculating the weighted voltage imbalance $\Delta_s$ by an equation:

$$\Delta_s = \frac{\Delta_{UAC}}{\left(1 - \dfrac{R_{DC}}{R_m + R_{DC}}\right)}$$

where $R_{DC}$ denotes the ground fault resistance and $R_m$ denotes the resistance of the first or second resistor; determining the sign of the voltage difference $\Delta V = V_1 - V_2$; selecting, based on the sign of the voltage difference, a predefined imbalance curve $\Lambda_{gl}$ representing the relationship between the voltage imbalance and the distance relative to the terminal of the series-connected primary windings in a case where the ground fault resistance is zero; and determining from the predefined imbalance curve a distance that corresponds to the calculated weighted voltage imbalance $\Delta_s$, the determined distance defining the distance between the terminal of the series-connected primary windings and the ground fault location.

According to an embodiment of the invention the imbalance curve $\Lambda_{gl}$ is selected from the following predefined set:

$$\Lambda_{gl} = S_m \cdot (1 - \Delta_s), \text{ when } V_1 \geq V_2$$

and

$$\Lambda_{gl} = S_m \cdot (1 + \Delta_s), \text{ when } V_1 < V_2,$$

where $S_m$ denotes the distance between the terminal and the physical centre of the series-connected primary windings. By the physical centre of the series-connected primary windings is meant a point in the primary circuit that is at the same distance from both terminals of the series-connected primary windings.

According to an embodiment of the invention the method comprises changing at least one the following parameters: the waveform, the amplitude and the frequency of the alternating voltage supplied by the constant-current regulator. By the amplitude of the alternating voltage is meant the voltage level. Preferably, at least two of these parameters, such as the amplitude and the frequency, are changed for determining the location of a ground fault. The changing of the alternating voltage can facilitate the measurement of the first and second voltages. Preferably, one or more parameters of the alternating voltage is changed outside the parameter area that is used during normal operation of the electrical circuit.

According to an embodiment of the invention the method comprises changing the amplitude of the alternating voltage within a predefined amplitude range and changing the frequency of the alternating voltage within a predefined frequency range. The predefined amplitude range and the predefined frequency range define the area inside which the amplitude and the frequency of the alternating voltage can be changed. The predefined amplitude range can be, for example, from 20 V to 5 kV. The predefined frequency range can be, for example, from 50 Hz to 1000 Hz.

The present invention also relates to an electrical circuit. The electrical circuit according to the invention comprises the features of claim 8.

The electrical circuit according to the invention is a lighting circuit that has a built-in functionality to determine the location of a ground fault in it. The electrical circuit can be used in an aeronautical ground lighting (AGL) system, which provides visual cues in runways and taxiways to help aircraft pilots during approach, landing and taxiing. In the electrical circuit according to the invention, the series-connected primary windings of the transformers form a primary circuit. The CCR is electrically connected to the primary circuit for supplying AC power to the primary windings. Each of the secondary windings of the transformers forms a secondary circuit with one of the LEDs.

During normal operation of the electrical circuit, the CCR supplies electric power through the transformers to the LEDs, which then emit light. The transformers isolate the LEDs from the high operating voltage of the primary circuit and ensure the circuit continuity in case of a LED failure.

A ground fault may occur in the primary circuit, for example due to an insulation breakdown in an electrical cable between the primary windings. In the electrical circuit according to the invention, the location of such a fault can be determined based on two measured voltages. The voltages that are used in determining the location of the ground fault are the first and second voltages measured over the first and second resistors. The first and second voltages can be measured with a voltmeter that measures electrical potential difference between two points in an electrical circuit. The means for determining the location of a ground fault in the electrical circuit based on the measured first and second voltages may comprise a processor and a memory including computer program code, the memory and the computer program code being configured to, with the processor, calculate the location of the ground fault.

An advantage of the electrical circuit according to the invention is that the location of a ground fault in the electrical circuit can be determined in a quick and accurate manner.

According to an embodiment of the invention the electrical circuit comprises means for determining a ground fault resistance, and means for determining the location of the ground fault in the electrical circuit based on at least the measured first and second voltages and the determined ground fault resistance. The means for determining a ground fault resistance may comprise a third resistor having a first terminal and a second terminal, the first terminal being electrically connected to a node between the first resistor and the second resistor, a power source electrically connected to the second terminal of the third resistor for supplying DC power, means for measuring a current through the third resistor, and means for determining a ground fault resistance based on the measured current.

According to an embodiment of the invention the constant-current regulator comprises means for changing at least one the following parameters: the waveform, the amplitude and the frequency of the alternating voltage supplied by the constant-current regulator.

The exemplary embodiments of the invention presented in this text are not interpreted to pose limitations to the applicability of the appended claims. The verb "to comprise" is used in this text as an open limitation that does not exclude the existence of also unrecited features. The features recited in the dependent claims are mutually freely combinable unless otherwise explicitly stated.

The exemplary embodiments presented in this text and their advantages relate by applicable parts to the method as well as the electrical circuit according to the invention, even though this is not always separately mentioned.

BRIEF DESCRIPTION OF THE DRAWINGS

Fig. 1     illustrates an electrical circuit according to an embodiment of the invention,

fig. 2     illustrates first examples of imbalance curves, and

fig. 3     illustrates second examples of imbalance curves.

DETAILED DESCRIPTION OF THE DRAWINGS

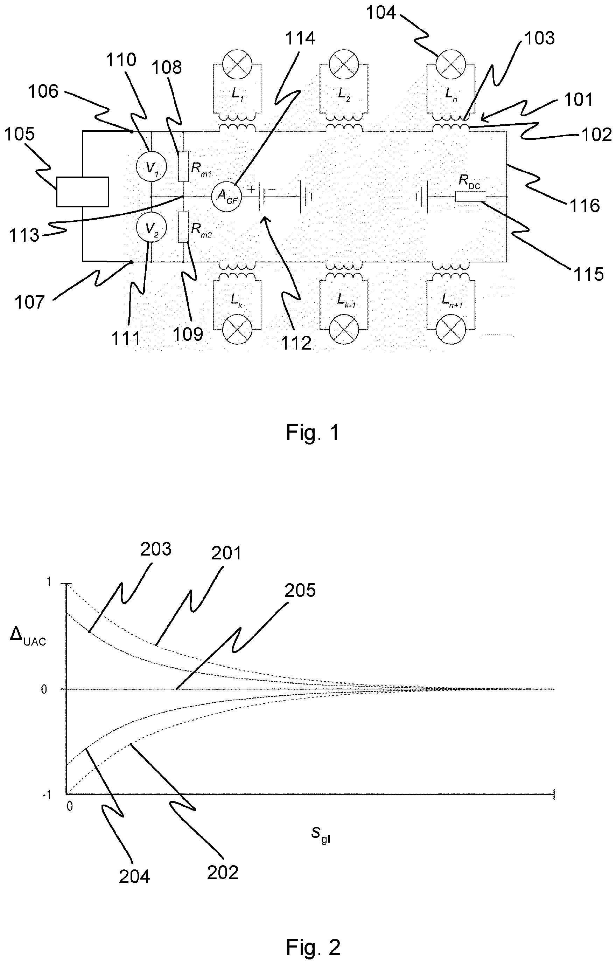

Fig. 1 illustrates an electrical circuit according to an embodiment of the invention. The electrical circuit comprises a plurality of transformers 101, which each have a primary winding 102 and a secondary winding 103. The primary windings 102 are electrically connected in series so that they form a primary circuit. The electrical circuit also comprises a plurality of light-emitting diodes (LEDs) 104, each of which is electrically connected to one of the secondary windings 103. Each of the secondary windings 103 forms a secondary circuit with one of the LEDs 104. The transformers 101 isolate the LEDs 104 from the high operating voltage of the primary circuit and ensure the circuit continuity in case of the LED 104 failure.

The electrical circuit comprises a constant-current regulator (CCR) 105 that is electrically connected to terminals 106 and 107 of the series-connected primary windings 102, i.e. the primary circuit. During normal operation of the electrical circuit, the CCR 105 supplies electric power through the transformers 101 to the LEDs 104, which then emit light.

The electrical circuit comprises resistors 108 and 109, which are electrically connected in series between the terminals 106 and 107, and voltmeters 110 and 111, which are arranged to measure the voltages over the resistors 108 and 109, respectively. The electrical circuit also comprises a power source 112 for supplying DC power to the primary circuit through a node 113 between the resistors 108 and 109. The current supplied by the power source 112 can be measured with an ammeter 114.

In the electrical circuit of fig. 1, there is a ground fault that allows an unintended connection of the primary circuit with the ground. The ground fault is illustrated with a resistor 115 through which current may flow from an electrical cable (primary cable) 116 to the ground. The location of the ground fault can be determined based on the voltages over the resistors 108 and 109, and a ground fault resistance. The ground fault resistance is the resistance of the resistor 115. The ground fault resistance can be determined based on the current measured by the ammeter 114.

Fig. 2 illustrates first examples of imbalance curves. Each imbalance curve 201, 202, 203 and 204 describes, for a specific value of the ground fault resistance, the relationship between the voltage imbalance and the distance between one of the terminals of the primary circuit and the ground fault location. The imbalance curves 201 and 202 correspond to a situation where the ground fault resistance is zero, and the imbalance curves 203 and 204 a situation where the ground fault resistance differs from zero. The imbalance curves 201, 202, 203 and 204 monotonically approach a balance curve 205 (corresponding to a situation when the voltage imbalance is zero) and meet it at a point that corresponds to the electrically furthermost point in the primary circuit. The imbalance curves 201, 202, 203 and 204 are of the same shape but differently scaled depending on the ground fault resistance. The sign (polarity) of the voltage imbalance denotes which terminal of the primary circuit is electrically closer to the location of the ground fault. Based on the sign of the voltage imbalance, the correct imbalance curve can be used in determining the distance between the terminal of the primary circuit and the ground fault location.

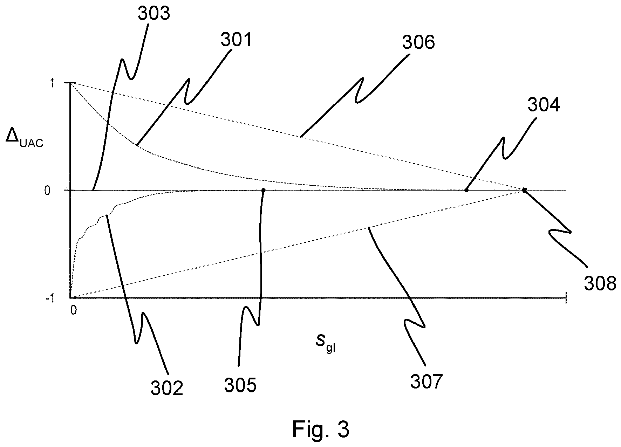

Fig. 3 illustrates second examples of imbalance curves. Asymmetrical imbalance curves 301 and 302 represent an electrical circuit in which the locations of the electrical centre and the physical centre of the primary circuit differ from each other. The imbalance curve 301 meets a balance curve 303 (corresponding to a situation when the voltage imbalance is zero) at a point 304, and the imbalance curve 302 meets the balance curve at a point 305. The sum of the distances of the points 304 and 305 corresponds to the length of the primary circuit. Imbalance curves 306 and 307 represent linear approximations of the relationship between the voltage imbalance and the distance between one of the terminals of the primary circuit and the ground fault location for an electrical circuit having a simple response. The imbalance curves 306 and 307 meet the balance curve 303 at a point 308.

The imbalance curves 302 and 307 illustrate the difference between a primary winding induced impedance (curve 302) and a purely primary cable induced impedance (curve 307). In an idealised case, the cable induced impedance is spread evenly throughout the circuit length, whereas the primary winding induced impedance is discretely distributed. A realistic implementation is always a combination between these two extreme cases. The secondary impedances also have an effect on the AC-imbalance. The effect of the secondary impedances can be reduced to the primary winding impedance and considered as one entity.

Only advantageous exemplary embodiments of the invention are described in the figures. It is clear to a person skilled in the art that the invention is not restricted only to the examples presented above, but the invention may vary within the limits of the claims presented hereafter. Some possible embodiments of the invention are described in the dependent claims, and they are not to be considered to restrict the scope of protection of the invention as such.

**Claims**

1. A method for determining the location of a ground fault in an electrical circuit that comprises a plurality of transformers (101), each transformer (101) having a primary winding (102) and a secondary winding (103), the primary windings (102) being electrically connected in series and each secondary winding (103) being electrically connected to a light-emitting diode (104), **characterised in that** the method comprises:

   - using, after the occurrence of a ground fault, a constant-current regulator (105) to supply AC power to the series-connected primary windings (102),
   - measuring a first voltage over a first resistor (108) and a second voltage over a second resistor (109), the first resistor (108) and the second resistor (109) being electrically connected in series and between a first terminal (106) and a second terminal (107) of the series-connected primary windings (102), and
   - determining the location of the ground fault based on at least the measured first and second voltages.

2. The method according to claim 1, **characterised in that** the location of the ground fault is determined by using an equation:

$$n = \frac{kV_1}{V_1 + V_2}$$

where n denotes the number of the primary windings (102) between the first terminal (106) and the ground fault location, k denotes the total number of the primary windings (102), $V_1$ denotes the first voltage and $V_2$ denotes the

second voltage.

3. The method according to claim 1, **characterised in that** the method comprises:

- determining a ground fault resistance, and
- determining the location of the ground fault based on at least the measured first and second voltages and the determined ground fault resistance.

4. The method according to claim 3, **characterised in that** the step of determining the location of the ground fault based on at least the measured first and second voltages and the determined ground fault resistance comprises:

- calculating the voltage imbalance $\Delta_{\text{UAC}}$ by an equation:

$$\Delta_{\text{UAC}} = \frac{V_1 - V_2}{V_1 + V_2}$$

where $V_1$ denotes the first voltage and $V_2$ denotes the second voltage,
- calculating the weighted voltage imbalance $\Delta_{\text{s}}$ by an equation:

$$\Delta_{\text{s}} = \frac{\Delta_{\text{UAC}}}{\left(1 - \frac{R_{\text{DC}}}{R_{\text{m}} + R_{\text{DC}}}\right)}$$

where $R_{\text{DC}}$ denotes the ground fault resistance and $R_{\text{m}}$ denotes the resistance of the first or second resistor (108, 109),
- determining the sign of the voltage difference $\Delta V = V_1 - V_2$,
- selecting, based on the sign of the voltage difference, a predefined imbalance curve $\Lambda_{\text{gl}}$ representing the relationship between the voltage imbalance and the distance relative to the terminal of the series-connected primary windings (102) in a case where the ground fault resistance is zero, and
- determining from the predefined imbalance curve a distance that corresponds to the calculated weighted voltage imbalance $\Delta_{\text{s}}$, the determined distance defining the distance between the terminal (106) of the series-connected primary windings (102) and the ground fault location.

5. The method according to claim 4, **characterised in that** the imbalance curve $\Lambda_{\text{gl}}$ is selected from the following predefined set:

$$\Lambda_{\text{gl}} = S_{\text{m}} \cdot (1 - \Delta_{\text{s}}), \text{ when } V_1 \geq V_2$$

and

$$\Lambda_{\text{gl}} = S_{\text{m}} \cdot (1 + \Delta_{\text{s}}), \text{ when } V_1 < V_2,$$

where $S_{\text{m}}$ denotes the distance between the terminal (106) and the physical centre of the series-connected primary windings (102).

6. The method according to any of the preceding claims, **characterised in that** the method comprises changing at least one the following parameters: the waveform, the amplitude and the frequency of the alternating voltage supplied by the constant-current regulator (105).

7. The method according to claim 6, **characterised in that** the method comprises changing the amplitude of the alternating voltage within a predefined amplitude range and changing the frequency of the alternating voltage within a predefined frequency range.

8. An electrical circuit, comprising:

- a plurality of transformers (101), each transformer (101) having a primary winding (102) and a secondary winding (103), the primary windings (102) being electrically connected in series,
- a plurality of light-emitting diodes (104), each light-emitting diode (104) being electrically connected to one of the secondary windings (103), and **characterised in that** the electrical circuit comprises:
- a constant-current regulator (105) electrically connected to the series-connected primary windings (102) for supplying AC power to the primary windings (102) after the occurrence of a ground fault,
- a first resistor (108) and a second resistor (109) electrically connected in series and between a first terminal (106) and a second terminal (107) of the series-connected primary windings (102),
- means (110, 111) for measuring a first voltage over the first resistor (108) and a second voltage over the second resistor (109), and
- means for determining the location of a ground fault in the electrical circuit based on at least the measured first and second voltages.

9. The electrical circuit according to claim 8, **characterised in that** the electrical circuit comprises:

- means (112, 114) for determining a ground fault resistance, and
- means for determining the location of the ground fault in the electrical circuit based on at least the measured first and second voltages and the determined ground fault resistance.

10. The electrical circuit according to claim 8 or 9, **characterised in that** the constant-current regulator (105) comprises means for changing at least one the following parameters: the waveform, the amplitude and the frequency of the alternating voltage supplied by the constant-current regulator (105).

**Patentansprüche**

1. Verfahren zum Bestimmen der Stelle eines Erdschlusses in einer elektrischen Schaltung, die eine Vielzahl von Transformatoren (101) umfasst, wobei jeder Transformator (101) eine Primärwicklung (102) und eine Sekundärwicklung (103) aufweist, wobei die Primärwicklungen (102) elektrisch in Reihe geschaltet sind und jede Sekundärwicklung (103) elektrisch mit einer lichtemittierenden Diode (104) verbunden ist, **dadurch gekennzeichnet, dass** das Verfahren Folgendes umfasst:

- Verwenden, nach dem Auftreten eines Erdschlusses, eines Konstantstromreglers (105), um Wechselstrom an die in Reihe geschalteten Primärwicklungen (102) zu liefern,
- Messen einer ersten Spannung über einem ersten Widerstand (108) und einer zweiten Spannung über einem zweiten Widerstand (109), wobei der erste Widerstand (108) und der zweite Widerstand (109) elektrisch in Reihe und zwischen einem ersten Anschluss (106) und einem zweiten Anschluss (107) der in Reihe geschalteten Primärwicklungen (102) geschaltet sind, und
- Bestimmen der Stelle des Erdschlusses basierend auf mindestens den gemessenen ersten und zweiten Spannungen.

2. Verfahren nach Anspruch 1, **dadurch gekennzeichnet, dass** die Stelle des Erdschlusses durch Verwenden einer Gleichung bestimmt wird:

$$ n = \frac{kV_1}{V_1 + V_2} $$

wobei n die Anzahl der Primärwicklungen (102) zwischen dem ersten Anschluss (106) und der Erdschlussstelle bezeichnet, $k$ die Gesamtzahl der Primärwicklungen (102) bezeichnet, $V_1$ die erste Spannung bezeichnet und $V_2$ die zweite Spannung bezeichnet.

3. Verfahren nach Anspruch 1, **dadurch gekennzeichnet, dass** das Verfahren Folgendes umfasst:

- Bestimmen eines Erdschlusswiderstands, und
- Bestimmen der Stelle des Erdschlusses basierend auf mindestens den gemessenen ersten und zweiten Spannungen und dem bestimmten Erdschlusswiderstand.

4. Verfahren nach Anspruch 3, **dadurch gekennzeichnet, dass** der Schritt des Bestimmens der Stelle des Erdschlusses basierend auf mindestens den gemessenen ersten und zweiten Spannungen und dem bestimmten Erdschlusswiderstand Folgendes umfasst:

- Berechnen des Spannungsungleichgewichts $\Delta_{UAC}$ durch eine Gleichung:

$$\Delta_{UAC} = \frac{V_1 - V_2}{V_1 + V_2}$$

wobei $V_1$ die erste Spannung bezeichnet und $V_2$ die zweite Spannung bezeichnet,
- Berechnen des gewichteten Spannungsungleichgewichts $\Delta_s$ durch eine Gleichung:

$$\Delta_s = \frac{\Delta_{UAC}}{\left(1 - \frac{R_{DC}}{R_m + R_{DC}}\right)}$$

wobei $R_{DC}$ den Erdschlusswiderstand bezeichnet und $R_m$ den Widerstand des ersten oder zweiten Widerstands bezeichnet (108, 109),
- Bestimmen des Vorzeichens der Spannungsdifferenz $\Delta V = V_1 - V_2$,
- Auswählen, basierend auf dem Vorzeichen der Spannungsdifferenz, einer vordefinierten Ungleichgewichtskurve $\Lambda_{gl}$, die die Beziehung zwischen dem Spannungsungleichgewicht und dem Abstand relativ zum Anschluss der in Reihe geschalteten Primärwicklungen (102) in einem Fall darstellt, in dem der Erdschlusswiderstand Null ist, und
- Bestimmen aus der vordefinierten Ungleichgewichtskurve eines Abstands, der dem berechneten gewichteten Spannungsungleichgewicht $\Delta_s$ entspricht, wobei der bestimmte Abstand den Abstand zwischen dem Anschluss (106) der in Reihe geschalteten Primärwicklungen (102) und der Erdschlussstelle definiert.

5. Verfahren nach Anspruch 4, **dadurch gekennzeichnet, dass** die Ungleichgewichtskurve $\Lambda_{gl}$ aus dem folgenden vordefinierten Satz ausgewählt wird:

$$\Lambda_{gl} = S_m \cdot (1 - \Delta_s), \text{ wenn } V_1 \geq V_2$$

und

$$\Lambda_{gl} = S_m \cdot (1 + \Delta_s), \text{ wenn } V_1 < V_2,$$

wobei $S_m$ den Abstand zwischen dem Anschluss (106) und dem physikalischen Mittelpunkt der in Reihe geschalteten Primärwicklungen (102) bezeichnet.

6. Verfahren nach einem der vorhergehenden Ansprüche, **dadurch gekennzeichnet, dass** das Verfahren das Ändern mindestens eines der folgenden Parameter umfasst: die Wellenform, die Amplitude und die Frequenz der vom Konstantstromregler (105) gelieferten Wechselspannung.

7. Verfahren nach Anspruch 6, **dadurch gekennzeichnet, dass** das Verfahren das Ändern der Amplitude der Wechselspannung innerhalb eines vordefinierten Amplitudenbereichs und das Ändern der Frequenz der Wechselspannung innerhalb eines vordefinierten Frequenzbereichs umfasst.

8. Elektrische Schaltung, die Folgendes umfasst:

- eine Vielzahl von Transformatoren (101), wobei jeder Transformator (101) eine Primärwicklung (102) und eine Sekundärwicklung (103) aufweist, wobei die Primärwicklungen (102) elektrisch in Reihe geschaltet sind,
- eine Vielzahl von lichtemittierenden Dioden (104), wobei jede lichtemittierende Diode (104) elektrisch mit einer der Sekundärwicklungen (103) verbunden ist, und **dadurch gekennzeichnet, dass** die elektrische Schaltung Folgendes umfasst:
- einen Konstantstromregler (105), der elektrisch mit den in Reihe geschalteten Primärwicklungen (102) zum Liefern von Wechselstrom an die Primärwicklungen (102) nach dem Auftreten eines Erdschlusses verbunden ist,
- einen ersten Widerstand (108) und einen zweiten Widerstand (109), die elektrisch in Reihe und zwischen einen ersten Anschluss (106) und einen zweiten Anschluss (107) der in Reihe geschalteten Primärwicklungen (102) geschaltet sind,
- Mittel (110, 111) zum Messen einer ersten Spannung über dem ersten Widerstand (108) und einer zweiten Spannung über dem zweiten Widerstand (109), und
- Mittel zum Bestimmen der Stelle eines Erdschlusses in dem Stromkreis basierend auf mindestens den gemessenen ersten und zweiten Spannungen.

9. Elektrische Schaltung nach Anspruch 8, **dadurch gekennzeichnet, dass** die elektrische Schaltung Folgendes umfasst:

- Mittel (112, 114) zum Bestimmen eines Erdschlusswiderstands, und
- Mittel zum Bestimmen der Stelle des Erdschlusses in der elektrischen Schaltung basierend auf mindestens den gemessenen ersten und zweiten Spannungen und dem bestimmten Erdschlusswiderstand.

10. Elektrische Schaltung nach Anspruch 8 oder 9, **dadurch gekennzeichnet, dass** der Konstantstromregler (105) Mittel zum Ändern mindestens eines der folgenden Parameter umfasst: die Wellenform, die Amplitude und die Frequenz der vom Konstantstromregler (105) gelieferten Wechselspannung.

## Revendications

1. Procédé pour déterminer l'emplacement d'un défaut à la terre dans un circuit électrique qui comprend une pluralité de transformateurs (101), chaque transformateur (101) ayant un enroulement primaire (102) et un enroulement secondaire (103), les enroulements primaires (102) étant connectés électriquement en série et chaque enroulement secondaire (103) étant connecté électriquement à une diode électroluminescente (104), **caractérisé en ce que** le procédé comprend :

- l'utilisation, après l'apparition d'un défaut à la terre, d'un régulateur de courant constant (105) pour fournir du courant alternatif aux enroulements primaires (102) connectés en série,
- la mesure d'une première tension sur une première résistance (108) et d'une seconde tension sur une seconde résistance (109), la première résistance (108) et la seconde résistance (109) étant connectées électriquement en série et entre une première borne (106) et une seconde borne (107) des enroulements primaires (102) connectés en série, et
- la détermination de l'emplacement du défaut à la terre sur la base au moins des première et seconde tensions mesurées.

2. Procédé selon la revendication 1, **caractérisé en ce que** la localisation du défaut à la terre est déterminée à l'aide d'une équation :

$$n = \frac{kV_1}{V_1 + V_2}$$

où n désigne le nombre d'enroulements primaires (102) entre la première borne (106) et l'emplacement de défaut à la terre, $k$ désigne le nombre total d'enroulements primaires (102), $V_1$ désigne la première tension et $V_2$ désigne la seconde tension.

3. Procédé selon la revendication 1, **caractérisé en ce que** le procédé comprend :

- la détermination d'une résistance de défaut à la terre, et
- la détermination de l'emplacement du défaut à la terre sur la base au moins des première et seconde tensions mesurées et de la résistance de défaut à la terre déterminée.

4. Procédé selon la revendication 3, **caractérisé en ce que** l'étape de détermination de l'emplacement du défaut à la terre sur la base au moins des première et seconde tensions mesurées et de la résistance de défaut à la terre déterminée comprend :

- le calcul du déséquilibre de tension $\Delta_{UAC}$ par une équation :

$$\Delta_{UAC} = \frac{V_1 - V_2}{V_1 + V_2}$$

où $V_1$ désigne la première tension et $V_2$ désigne la seconde tension,
- le calcul du déséquilibre de tension pondéré $\Delta_s$ par une équation :

$$\Delta_s = \frac{\Delta_{UAC}}{\left(1 - \dfrac{R_{DC}}{R_m + R_{DC}}\right)}$$

où $R_{DC}$ désigne la résistance de défaut à la terre et $R_m$ désigne la résistance de la première ou seconde résistance (108, 109),
- la détermination du signe de la différence de

$$\Delta V = V_1 - V_2,$$

tension
- la sélection, sur la base du signe de la différence de tension, d'une courbe de déséquilibre prédéfinie $\Lambda_{gl}$ représentant la relation entre le déséquilibre de tension et la distance par rapport à la borne des enroulements primaires (102) connectés en série dans un cas où la résistance de défaut à la terre est zéro, et
- la détermination, à partir de la courbe de déséquilibre prédéfinie, d'une distance qui correspond au déséquilibre de tension pondéré calculé $\Delta_s$, de la distance déterminée définissant la distance entre la borne (106) des enroulements primaires (102) connectés en série et l'emplacement du défaut à la terre.

5. Procédé selon la revendication 4, **caractérisé en ce que** la courbe de déséquilibre $\Lambda_{gl}$ est sélectionnée parmi l'ensemble prédéfini suivant :

$$\Lambda_{gl} = S_m \cdot (1 - \Delta_s), \quad \text{lorsque } V_1 > V_2$$

et

$$\Lambda_{gl} = S_m \cdot (1 + \Delta_s), \quad \text{lorsque } V_1 < V_2,$$

où $S_m$ désigne la distance entre la borne (106) et le centre physique des enroulements primaires (102) connectés en série.

6. Procédé selon l'une quelconque des revendications précédentes, **caractérisé en ce que** le procédé comprend la modification d'au moins un des paramètres suivants : la forme d'onde, l'amplitude et la fréquence de la tension alternative fournie par le régulateur de courant constant (105).

7. Procédé selon la revendication 6, **caractérisé en ce que** le procédé comprend la modification de l'amplitude de la tension alternative dans une plage d'amplitudes prédéfinie et la modification de la fréquence de la tension alternative dans une plage de fréquences prédéfinie.

8. Circuit électrique, comprenant :

- une pluralité de transformateurs (101), chaque transformateur (101) ayant un enroulement primaire (102) et un enroulement secondaire (103), les enroulements primaires (102) étant connectés électriquement en série,
- une pluralité de diodes électroluminescentes (104), chaque diode électroluminescente (104) étant connectée électriquement à l'un des enroulements secondaires (103), et **caractérisé en ce que** le circuit électrique comprend :
- un régulateur de courant constant (105) connecté électriquement aux enroulements primaires (102) connectés en série pour fournir un courant alternatif aux enroulements primaires (102) après l'apparition d'un défaut à la terre,
- une première résistance (108) et une seconde résistance (109) connectées électriquement en série et entre une première borne (106) et une seconde borne (107) des enroulements primaires (102) connectés en série,
- des moyens (110, 111) pour mesurer une première tension sur la première résistance (108) et une seconde tension sur la seconde résistance (109), et
- des moyens pour déterminer l'emplacement d'un défaut à la terre dans le circuit électrique sur la base au moins des première et seconde tensions mesurées.

9. Circuit électrique selon la revendication 8, **caractérisé en ce que** le circuit électrique comprend :

- des moyens (112, 114) pour déterminer une résistance de défaut à la terre, et
- des moyens pour déterminer l'emplacement du défaut à la terre dans le circuit électrique sur la base au moins des première et seconde tensions mesurées et de la résistance de défaut à la terre déterminée.

10. Circuit électrique selon la revendication 8 ou 9, **caractérisé en ce que** le régulateur de courant constant (105) comprend des moyens pour modifier au moins un des paramètres suivants : la forme d'onde, l'amplitude et la fréquence de la tension alternative fournie par le régulateur de courant constant (105).

Fig. 1

Fig. 2

Fig. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012122752 A